**Europäisches Patentamt**

**European Patent Office**

**Office européen des brevets**

(11) Veröffentlichungsnummer: **0 397 911**
**A1**

(12) **EUROPÄISCHE PATENTANMELDUNG**

(21) Anmeldenummer: **89109085.4**

(22) Anmeldetag: **19.05.89**

(51) Int. Cl.[5]: **H01L 31/0232, H01L 33/00**

(43) Veröffentlichungstag der Anmeldung:
**22.11.90 Patentblatt 90/47**

(84) Benannte Vertragsstaaten:
**AT BE CH DE ES FR GB GR IT LI LU NL SE**

(71) Anmelder: **Siemens Aktiengesellschaft**
**Wittelsbacherplatz 2**
**D-8000 München 2(DE)**

(72) Erfinder: **Späth, Werner, Dipl.-Phys.**
**Burgstallerstrasse 10**
**D-8150 Holzkirchen(DE)**
Erfinder: **Jakowetz, Wolf, Dr.Dipl.-Phys.**
**Starenweg 21**
**D-8011 Vaterstetten(DE)**
Erfinder: **Schäfer, Herbert, Dr.Dipl.-Phys.**
**Unterhachinger Strasse 87a**
**D-8000 München 83(DE)**
Erfinder: **Besand, Michael, Dipl.-Phys.**
**J.Kistlerstrasse**
**D-8034 Germering(DE)**
Erfinder: **Osojnik, Karl, Dipl.-Ing.**
**Johann-Clanze-Strasse 31a**
**D-8000 München 70(DE)**

(54) **Optoelektronisches Halbleiterbauelement.**

(57) Ein optoelektronisches Halbleiterbauelement mit Lichtsende-oder -empfangseigenschaften, das eine parallel zur Oberfläche (3) eines Halbleiterkristalls (1) verlaufende, lichtemittierende oder -detektierende aktive Zone (2) aufweist, soll so ausgebildet sein, daß es seitlich, d.h. parallel zur aktiven Zone (2) einfallendes bzw. austretendes Licht mit hohem Wirkungsgrad detektieren bzw. emittieren kann, so daß insbesondere eine Hybridisierung des Bauelements mit anderen elektrischen, elektrooptischen oder optischen Elementen auf einer einzigen Ebene ermöglicht wird. Mindestens eine Seitenfläche (4) des Halbleiterkristalls (1) ist in einem solchen Winkel zu dessen Oberfläche (3) geneigt, daß in Parallelrichtung zur aktiven Zone (2) in den Halbleiterkristall (1) ein- oder aus diesem abgestrahltes Licht durch Brechung und/oder Reflexion eine Ablenkung zur aktiven Zone (2) hin bzw. von dieser weg erfährt.

Das erfindungsgemäße optoelektronische Halbleiterbauelement findet insbesondere als Lichtwellenleiter-(LWL-)Bauelement Anwendung.

FIG 1

## Optoelektronisches Halbleiterbauelement.

Die Erfindung betrifft ein optoelektronisches Halbleiterbauelement nach dem Oberbegriff des Anspruchs 1.

Derartige optoelektronische Halbleiterbauelemente sind allgemein bekannt und werden in zunehmendem Maße auch als Lichtwellenleiter-(LWL-)Bauelemente zur Nachrichtenübertragung mit Licht verwendet.

Beispielsweise besteht ein konventionelle Halbleiter-Fotodiode aus einem Halbleiterplättchen, wobei die lichtabsorbierende Schicht parallel zur Oberfläche des Plättchens verläuft. Der Wirkungsgrad einer solchen Diode ist dann maximal, wenn das Licht senkrecht zur absorbierenden Schicht bzw. aktiven Zone der Fotodiode einfällt.

Um mit solchen Dioden den beispielsweise von einem Halbleiter-Laser herrührenden Lichtstrahl oder das Austrittslicht aus einem Lichtwellenleiter bzw. einer Glasfaser detektieren zu können, müssen diese Bauelemente allerdings auf zueinander verkippten Ebenen aufgebaut werden, d.h. es ist ein räumlicher Aufbau erforderlich. Bedingt durch die notwendigerweise räumliche Anordnung der Einzelelemente zueinander sind die Montageplatten und die Montage selbst, z.B. das Bonden auf einer schiefen Ebene, sehr kostspielig bzw. sehr zeitaufwendig und fehleranfällig. Mit diesen Nachteilen sind in analoger Weise selbstverständlich auch lichtemittierende optoelektronische Bauelemente bzw. LWL-Halbleiterbauelemente wie z.B. Flächenemitter behaftet. Besonders problematisch ist eine solche Anordnung dann, wenn es gilt, derartige Bauelemente mit verschiedenen elektrischen, elektrooptischen Bauelementen, z.B. Laserdioden, und/oder anderen optischen Elementen, z.B. Kugellinsen oder Fasern, zu hybridisieren.

Der Erfindung liegt die Aufgabe zugrunde, eine optoelektronisches Halbleiterbauelement der eingangs genannte Art so auszubilden, daß es seitlich, d.h. parallel zur aktiven Zone einfallendes bzw. austretendes Licht mit hohem Wirkungsgrad detektieren bzw. emittieren kann, so daß insbesondere eine Hybridisierung des Bauelements mit anderen elektrischen, elektrooptischen oder optischen Elementen auf einer einzigen Ebene möglich ist.

Diese Aufgabe wird erfindungsgemäß durch ein optoelektronisches Halbleiterbauelement mit den Merkmalen des Anspruchs 1 gelöst.

Vorteilhafte Ausgestaltungen bzw. Weiterbildungen der Erfindung sind Gegenstand zusätzlicher Ansprüche.

Die mit der Erfindung erzielten Vorteile bestehen insbesondere darin, daß aufgrund der speziellen Formgebung eines an sich konventionellen optoelektronischen Halbleiterbauelements eine optimale seitliche Abstrahlung des in der aktiven Zone des Bauelements erzeugten Lichtes bzw. eine optimale Umwandlung von seitlich in das Bauelement einfallenden Licht in der aktiven Zone erreicht wird, und daß aufgrund des seitlichen Lichteinfalls bzw. seitlichen Lichtaustritts, d.h. in paralleler Richtung zur Oberfläche des Bauelements bzw. dessen aktiver Zone und nicht - wie üblich - in Richtung der Normalen, eine Anordnung derartige Bauelemente mit anderen bzw. andersartigen optischen, elektrischen oder optoelektronischen auf einer einzigen Fläche bzw. Ebene ermöglicht wird.

Dabei kann eine Fotodiode beispielsweise in Form einer planaren Halbleiter-Fotodiode Verwendung finden, wobei eine oder mehrere Seitenflächen in solchen Winkeln zueinander ausgebildet sind, daß das parallel zur aktiven Zone einfallende Licht durch Brechung und/oder Reflexion zur aktiven Zone hin abgelenkt wird. Diese zueinander geneigten Flächen müssen nicht unbedingt ebene Flächen, d.h. Flächen ersten Grades sein, sondern können gegebenenfalls sogar vorteilhafter auch als Flächen zweiten oder höheren Grades ausgebildet sein, um z.B. zusätzlich eine Fokussierung des Lichtstrahles bzw. Strahlbündels zu erreichen. Des weiteren kann es vorteilhaft sein, diese Seitenflächen mit geeignetem Material zu beschichten, um eine Ver- oder Entspiegelung zu erreichen.

Eine solche oder ähnliche Anordnung der Seitenflächen kann auch dazu verwendet werden, die Lichtstrahlen eines Flächenemitters so abzulenken, daß diese an einer Seitenfläche dieses optoelektronischen Halbleiterbauelementes austreten.

Es ist sinnvoll, solche erfindungsgemäße optoelektronische Halbleiterbauelemente, die vorzugsweise als LWL-Bauelemente verwendet werden, im Scheibenverband zu fertigen. Dazu ist es zweckmäßig, auf der gemeinsamen Halbleitersubstratscheibe (Wafer) an mindestens einer Seitenfläche des jeweiligen Einzelelements zusätzliches Substratmaterial für die Verbindung zu den benachbarten Bauelementen bereitzustellen bzw. für einen ausreichenden Abstand zwischen den einzelnen auf dem Wafer zu fertigenden Bauelementen zu sorgen, die nach ihrer Fertigstellung aus dem Scheibenverband z.B. durch Sägen oder Brechen vereinzelt werden.

Anhand von in den Figuren der Zeichnung schematisch dargestellten Ausführungsbeispielen wird die Erfindung weiter erläutert. Es zeigen

FIG 1 eine Empfängerdiode in upside up-Montage,

FIG 2 die Empfängerdiode nach FIG 1 in upside-down Montage,

FIG 3 und FIG 4 weitere Empfängerdioden,

FIG 5 einen Flächenemitter und

FIG 6 eine Empfängerdiode im Scheibenverband.

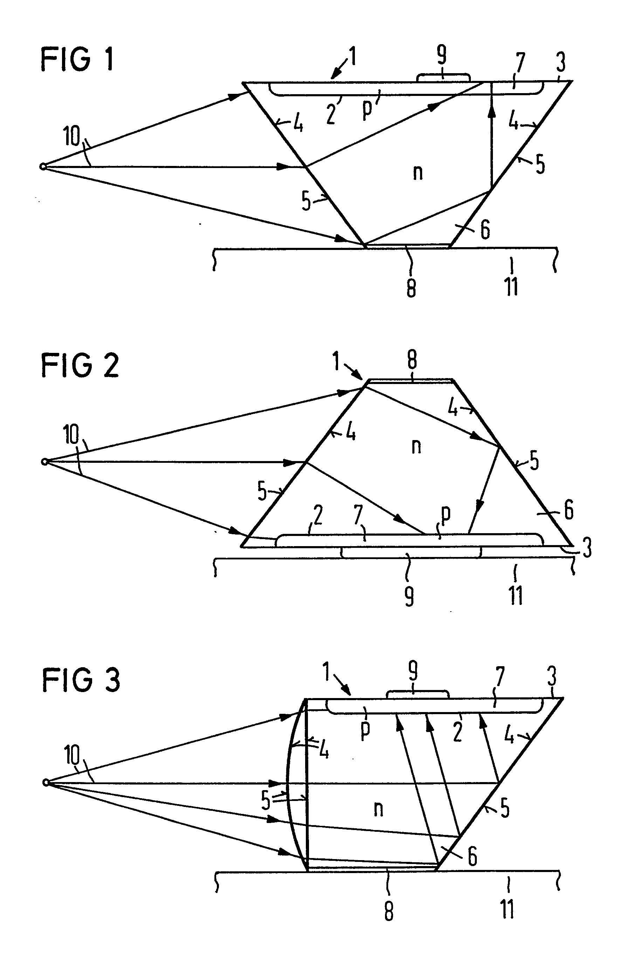

Die in den FIG 1 und FIG 2 dargestellten Empfängerdioden bestehen im wesentlichen aus einem Halbleiterkristall 1 aus einem n-leitenden Substrat 6, in dessen Oberfläche 3 ein p-Diffusionsgebiet 7 eindiffundiert ist, so daß ein ebener pn-Übergang gebildet ist, der die aktive Zone 2 des Bauelements darstellt. Das p-Diffusionsgebiet 7 ist mit einem p-Kontakt 9 und das n-Substrat 6 mit einer n-Kontaktschicht 8 versehen.

Eine auf der Oberfläche 3 des Halbleiterkristalls 1 vorgesehene Oberflächenpassivierung ist in den Figuren zur besseren Übersicht weggelassen.

Der Halbleiterkristall 1 ist in dem in FIG 1 dargestellten Ausführungsbeispiel in upside up-Montage auf einem Träger 11 angebracht, und zwar mit seiner der Oberfläche 3 bzw. der aktiven Zone 2 abgewandten Unterseite, die mit der n-Kontaktschicht 8 versehen ist. Der Träger 11 besteht beispielsweise aus Keramik oder Silizium und wird außerdem zum Kontaktieren oder zur Aufnahme von Leitungen bzw. Leiterbahnen verwendet. Bei dem in FIG 2 dargestellten Ausführungsbeispiel ist die Oberfläche 3 mit der aktiven Zone 2 der Empfängerdiode bzw. des Halbleiterkristalls 1 dem Träger 11 zugewandt und auf diesem in upside down-Montage befestigt. Die Befestigung erfolgt dabei über den p-Kontakt 9 mit dem das p-Diffusionsgebiet 7 im n-leitenden Substrat 6 des Halbleiterkristalls 1 versehen ist.

Die Seitenflächen 4 des Halbleiterkristalls 1 sind in einem solchen Winkel zu dessen Oberfläche 3 - die im Beispiel FIG 2 nach unten gekehrt (upside down) ist - geneigt, daß das in Form eines Lichtkegels 10 in den Halbleiterkristall 1 eingestrahlte Licht beim Eintritt in den Kristall 1 an der einen Seitenfläche 4 durch Brechung und dann im Inneren des Kristalls 1 an der anderen (gegenüberliegenden) Seitenfläche 4 durch Reflexion bzw. Totalreflexion zur aktiven bzw. lichtdetektierenden Zone 2 hin abgelenkt wird. Dieser Effekt läßt sich durch eine zusätzliche Vergütung oder Verspiegelung auf den Seitenflächen 4 noch erhöhen. Die Möglichkeit der Verwendung einer solchen Ver- oder Entspiegelung ist in den Figuren mit der Schicht 5 auf den Seitenflächen 4 angedeutet.

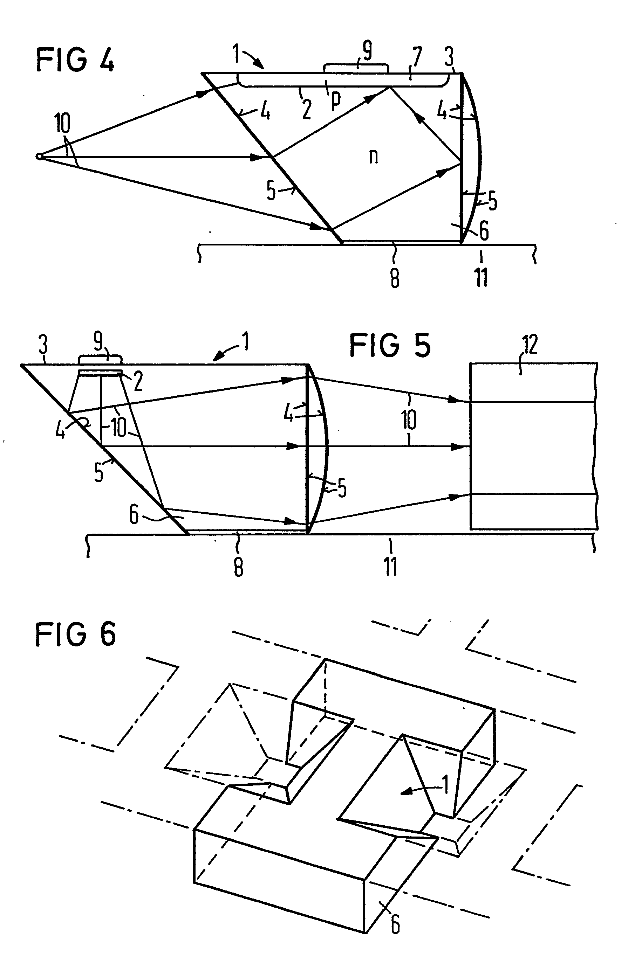

Die in den FIG 3 und FIG 4 dargestellten Empfängerdioden gleichen in ihrer inneren Struktur den Ausführungsbeispielen der FIG 1 und FIG 2, und beide Varianten lassen sich sowohl in upside down- als auch in der dargestellten upside up-Montagetechnik auf einem Träger 11 aus beispielsweise Silizium oder Keramik befestigen. Die Befestigung erfolgt dabei über die n-Kontaktschicht 8. Mit dieser Schicht ist das n-leitende Substrat 6 des Halbleiterkristalls 1 auf der Unterseite versehen. Diese Seite liegt der Oberfläche 3 bzw. dem p-Diffusionsgebiet 7 und dessen p-Kontakt 9 gegenüber.

Die Lichteinstrahlung in die Diode erfolgt in beiden Ausführungsbeispielen wiederum seitlich in Parallelrichtung zur aktiven Zone 2 im Halbleiterkristall 1. In dem Ausführungsbeispiel nach FIG 3 treffen die Lichtstrahlen 10 zunächst auf die als ebene Fläche (Fläche ersten Grades) oder als konvexe Fläche (Fläche zweiten Grades) ausgebildete Seitenfläche 4 und werden beim Übergang in das optisch dichtere Medium (Kristall 1) gebrochen und anschließend im Kristallinneren an der gegenüberliegenden Seitenfläche 4 in nahezu senkrechter Richtung zur aktiven Zone 2 hin reflektiert.

Bei dem in FIG 4 dargestellten Ausführungsbeispiel erfolgt die Lichtbrechung der in den Halbleiterkristall 1 einfallenden Lichtstrahlen 10 an der eben ausgebildeten Seitenfläche 4 aufgrund deren Neigung derart, daß bereits ein Teil des Strahlenbündels 10 direkt auf die aktive Zone 2 im Halbleiterkristall 1 abgelenkt wird, während der übrige Teil des Strahlenbündels 10 durch Reflexion bzw. Totalrefelxion an der anderen, eben oder konvex ausgebildeten Seitenfläche 4 zur aktiven Zone 2 hin abgelenkt wird.

Das in FIG 5 dargestellte optoelektronische Halbleiterbauelement ist als Flächenemitter ausgebildet und wird mit einer Glasfaser 12 gekoppelt vorzugsweise zur optischen Nachrichtenübertragung verwendet. Der Flächenemitter ist in seiner inneren Struktur konventioneller Art. Der Halbleiterkristall 1 weist dabei einen Heterostrukturaufbau auf. Beispielsweise wird bei einer Doppelheterostruktur die aktive Zone 2 geringer Dicke durch zwei Schichten mit höherem Bandabstand eingeschlossen. Der Halbleiterkristall 1 ist an seiner Oberfläche 3 mit einem p-Kontakt 9 versehen und mit seiner mit einer Kontaktschicht 8 versehenen Unterseite auf einem Träger 11, der beispielsweise aus Silizium oder Keramik besteht, seitlich gegenüber einer auf dem gleichen Träger 11 angeordneten Glasfaser 12 befestigt. Die in der aktiven Zone 2 erzeugten Lichtstrahlen 10 treten nahezu senkrecht aus dieser Zone 2 aus und werden dann aufgrund der zur Oberfläche 3 entsprechend geneigten Seitenfläche 4 des Kristalls 1 durch Totalreflexion auf die andere gegenüberliegende Seitenfläche 4 derart abgelenkt, daß sie den Halbleiterkristall 1 durch diese Seitenfläche 4 nahezu parallel zur aktiven Zone 2 bzw. zur Oberfläche 3 seitlich in Richtung der optischen Achse der Glasfaser 12 verlassen. Die der Glasfaser 12 zugewandte Seitenfläche 4 kann dabei vorzugsweise eine ebene oder eine konvexe Fläche sein. Außerdem kann es wiederum vorteilhaft sein, die Seitenflächen 4 mit einer Schicht 5 in gewünschter Weise zu vergüten.

In FIG 6 ist ein optoelektronisches Halbleiterbauelement in Form einer Empfängerdiode in einem Scheibenverband dargestellt. In einem solchen Verband läßt sich eine Vielzahl derartiger optoelektronischer Halbleiterbauelemente auf besonders rationelle Weise gleichzeitig herstellen. Als Ausgangsbasis dient eine gemeinsame Halbleitersubstratscheibe 6 (Wafer), in die die für die einzelnen Halbleiterkristalle 1 gewünschte Schichtenfolge eingebracht und aus der die geforderten Bauelementkonturen herausgeätzt werden. Dabei ist es besonders zweckmäßig, an mindestens einer Seitenfläche des jeweiligen Bauelements zusätzliches Substratmaterial für eine spätere Verbindung zu benachbarten Bauelementen bereitzustellen. Nach ihrer inneren und äußeren Strukturierung werden die Bauelemente aus dem Scheibenverband vereinzelt, fertig kontaktiert und gegebenenfalls von einem Gehäuse umgeben.

einer gemeinsamen Halbleitersubstratscheibe (6) hergestellt werden, daß dabei an mindestens einer Seitenfläche der Bauelemente zusätzliches Substratmaterial für die Verbindung zu benachbarten Bauelementen bereitgestellt wird, und daß die Bauelemente nach Fertigstellung aus dem Scheibenverband vereinzelt werden.

**Ansprüche**

1. Optoelektronisches Halbleiterbauelement mit Lichtsende-oder -empfangseigenschaften, das eine ebene, parallel zur Oberfläche eines Halbleiterkristalls verlaufende, lichtemittierende oder -detektierende aktive Zone aufweise, **dadurch gekennzeichnet**, daß mindestens eine Seitenfläche (4) des Halbleiterkristalls (1) in einem solchen Winkel zu dessen Oberfläche (3) geneigt ist, daß in Parallelrichtung zur aktiven Zone (2) in den Halbleiterkristall (1) ein- oder aus diesem abgestrahltes Licht durch Brechung und/oder Reflexion eine Ablenkung zur aktiven Zone (2) hin bzw. von dieser weg erfährt.

2. Optoelektronisches Halbleiterbauelement nach Anspruch 1, **dadurch gekennzeichnet**, daß die zur Oberfläche (3) des Halbleiterkristalls (1) geneigte(n) Seitenfläche(n) (4) Flächen ersten oder höheren Grades sind.

3. Optoelektronisches Halbleiterbauelement nach Anspruch 1 oder 2, **dadurch gekennzeichnet**, daß die Seitenflächen (4) des Halbleiterkristalls (1) mit einer Schicht (5) zur Ver- oder Entspiegelung versehen sind.

4. Optoelektronisches Halbleiterbauelement nach einem der Ansprüche 1 bis 3, **dadurch gekennzeichnet**, daß das Halbleiterbauelement eine Fotodiode ist.

5. Optoelektronisches Halbleiterbauelement nach einem der Ansprüche 1 bis 3, **dadurch gekennzeichnet**, daß das Halbleiterbauelement ein Flächenemitter ist.

6. Verfahren zum Herstellen eines optoelektronischen Halbleiterbauelements nach einem der Ansprüche 1 bis 5, **dadurch gekennzeichnet**, daß eine Vielzahl einzelner Halbleiterbauelemente auf

89 P 1386 E

FIG 1

FIG 2

FIG 3

FIG 4

FIG 5

FIG 6

Europäisches Patentamt

**EUROPÄISCHER RECHERCHENBERICHT**

Nummer der Anmeldung

EP 89 10 9085

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | PATENT ABSTRACTS OF JAPAN, Band 4, Nr. 63 (E-10) [545], 13th May 1980; & JP-A-55 33 028 (OKI DENKI KOGYO K.K.) 08-03-1980 * Insgesamt * --- | 1,2,5 | H 01 L 31/023 H 01 L 33/00 |
| X | GB-A-3 443 140 (GENERAL ELECTRIC CO.) * Spalte 5, Zeile 45 - Spalte 6, Zeile 38; Figur 2B * --- | 1,2,5 | |
| A | IBM TECHNICAL DISCLOSURE BULLETIN, Band 13, Nr. 3, August 1970, Seiten 591-592, New York, US; L.B. RICHARDS: "Photodetector as function detector" * Insgesamt * --- | 1-4 | |
| A | DE-A-2 416 098 (SIEMENS AG) * Insgesamt * --- | 1,2,5 | |
| A | US-A-4 358 676 (R.B. CHILDS et al.) * Insgesamt * --- | 1,2,4 | RECHERCHIERTE SACHGEBIETE (Int. Cl.5) |
| A | PATENT ABSTRACTS OF JAPAN, Band 12, Nr. 328 (E-654)[3175], 6. September 1988; & JP-A-63 90 866 (NEL CORP.) 21-04-1988 * Insgesamt * ----- | 1,2,4 | H 01 L |

Der vorliegende Recherchenbericht wurde für alle Patentansprüche erstellt

| Recherchenort | Abschlußdatum der Recherche | Prüfer |
|---|---|---|
| DEN HAAG | 19-01-1990 | LINA F. |